# EUROPEAN PATENT APPLICATION

(11) **EP 4 664 774 A1**
(43) Date of publication of application: **17.12.2025**
(21) Application number: 25178767.7
(22) Date of filing: 26.05.2025
(51) Int. Cl.: H04B 3/00, H04L 25/02

(54) **GALVANICALLY-ISOLATED COMMUNICATION CIRCUIT AND METHOD OF TRANSMITTING A DATA SIGNAL ACROSS A CAPACITIVE ISOLATION BARRIER**

(30) Priority: 13.06.2024 IT 202400013582
(71) Applicant: STMicroelectronics International N.V., 1228 Plan-les-Ouates, Geneva (CH)
(72) Inventor: PULVIRENTI, Francesco, I-95024 Acireale (Catania) (IT); SIGNORELLI, Tiziana Teresa, I-95020 Aci Bonaccorsi (Catania) (IT)
(74) Representative: Buzzi, Notaro & Antonielli d'Oulx S.p.A.

(57) **Abstract**

In a galvanically-isolated communication circuit (70), an input (702) receives an input data signal *(Data IN).* A first transmitter (704a) transmits a first carrier (*TX OUT_a*) while the input data signal is asserted, and a second transmitter (704b) transmits a second carrier (*TX_OUT_b*) while the input data signal *(Data IN)* is de-asserted. A first capacitive barrier (712a) is coupled to the first transmitter (704a) to propagate the first carrier, and a second capacitive barrier (712b) is coupled to the second transmitter (704b) to propagate the second carrier. A receiver (708) is coupled to first and second capacitive barriers and is configured to: demodulate the first carrier to produce a replica of the input data signal *(Data IN),* and demodulate the second carrier to produce a complemented replica of the input data signal . A selector (709) is coupled to the receiver and is configured to produce an output data signal (*Data_OUT*) at an output terminal (710) by: passing the replica of the input data signal *(Data IN)* in response to a masking time interval elapsing after a falling edge of the output data signal (*Data_OUT*), and passing the complement of the complemented replica of the input data signal *(Data IN)* in response to a masking time interval elapsing after a rising edge of the output data signal (*Data_OUT*).

## Description

### Technical field

The description relates to galvanically-isolated communication circuits and, in particular, to circuits having a communication channel that provides both functional and galvanic isolation.

### Technological background

Galvanic isolation is desired in those applications where user safety and isolation from the electrical grid has to be guaranteed. Such applications include, for instance, consumer, industrial and automotive applications. In battery chargers, for example, physical separation is necessary between the low-voltage section, which is accessible to the user, and the high-voltage section. Similarly, in industrial applications, such as high-voltage control circuits, control and communication systems, measurement and testing systems, signals are transmitted through galvanic isolation, eliminating any conductive path between the two parts to be isolated. In addition, there are many other applications where isolators are also used as level shifters to swing a signal between two different voltage references; in these cases, the minimum requirement of functional isolation is requested according to the maximum operating voltage.

Normally, transformers are used in systems where power needs to be transferred across an isolation barrier, while optocouplers are preferred for signal and data transfer. In recent years, new devices with integrated galvanic isolation are available on the market, which are gradually replacing classic architectures with discrete optocouplers, with the advantage of providing more compact solutions but also more performing in terms of consumption and reliability. These devices are made with different technologies that allow the transfer of information, while ensuring adequate isolation, according to the most severe international regulations.

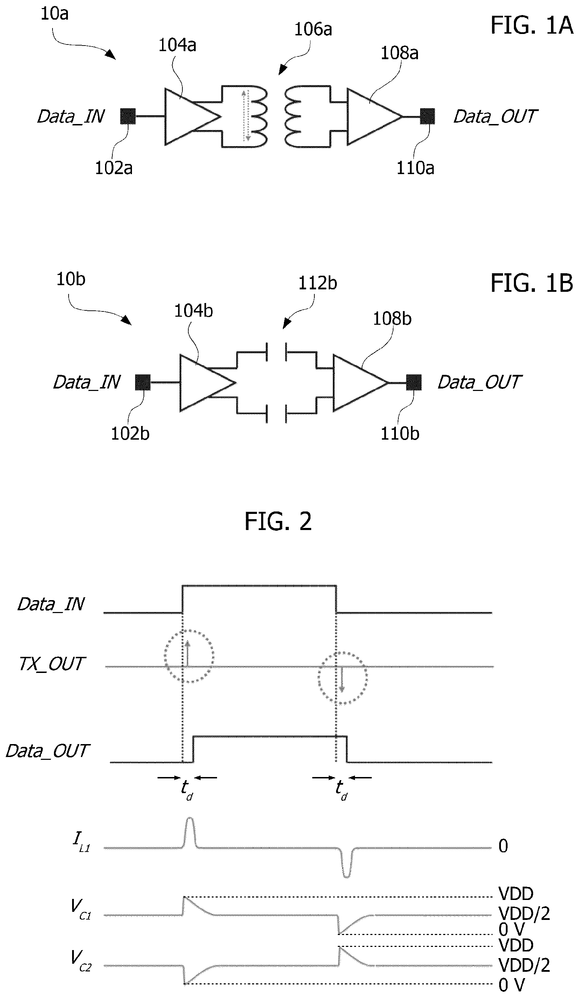

For instance, Figures 1A and 1B are circuit diagrams exemplary of two possible implementations of a communication channel through an embedded galvanic isolation physical barrier, the first one 10a (Figure 1A) based on a coreless transformer, and the second one 10b (Figure 1B) based on high-voltage (HV) capacitors.

The first implementation 10a shown in Figure 1A includes an input terminal 102a configured to receive an input (digital) data signal *Data_IN,* a transmitter circuit 104a coupled to the input terminal 102a and having a differential output, a coreless transformer 106a having a primary side coupled to the output of the transmitter 104a, a receiver circuit 108a having a differential input coupled to the secondary side of the transformer 106a, and an output terminal 110a coupled to the receiver 108a and configured to produce an output (digital) data signal *Data_OUT.* The output stage of the transmitter 104a is capable of driving in current the coreless transformer 106a. The input stage of the receiver 108a is designed to read the current from the secondary side of the transformer 106a.

The second implementation 10b shown in Figure 1B implements the embedded galvanic isolation barrier with HV capacitors instead of a transformer. The second implementation 10b thus includes an input terminal 102b configured to receive signal *Data_IN,* a transmitter circuit 104b coupled to the input terminal 102b and having a differential output, a pair of HV capacitors 112b each having a first terminal coupled to a respective output of the transmitter 104b, a receiver circuit 108b having a differential input coupled to the second terminals of the capacitors 112b, and an output terminal 110b coupled to the receiver 108b and configured to produce signal *Data_OUT.* The output stage of the transmitter 104b is designed to drive in voltage the HV capacitors 112b.

In both implementations exemplified in Figures 1A and 1B, data transmission is differential so as to discriminate the data signal from common mode transients (CMTs), which explains the presence of two capacitors 112b. The input stage of the receiver has a low impedance so as to reject the common mode transients.

The transmission protocols used in the above-mentioned architectures may be based on pulse transmission technique or on On-Off Keying (OOK) modulation. The pulse transmission technique is based on the transmission of current or voltage pulses each time the data signal *Data_IN* changes status (e.g., from low to high or vice versa). The OOK modulation technique is based on the transmission of a carrier when the data signal *Data_IN* is asserted (e.g., high, "1" logic level) and no transmission of the carrier when the data signal *Data_IN* is de-asserted (e.g., low, "0" logic level). The pulse transmission technique can be applied to both the implementations of Figures 1A and 1B, while the OOK modulation is usually applied to the implementation of Figure 1B. In the latter case, the signals have a square waveform and are differential to discriminate the data signal from common mode transients.

The pulse transmission technique may be weak versus common mode transients, because the signal transmission can be lost during these events, with a consequent loss of the information. Robustness against common mode transients may be improved by implementing a recovery procedure, at the expense of increased current consumption and increased complexity. On the other hand, OOK modulation may show longer propagation delays and worse matching with respect to the pulse technique, as well as asymmetric current consumption at the transmitter side (depending on whether a logic "0" or logic "1" is being transmitted), and high jitter on the output data signal in the case of high-to-low signals transitions.

Therefore, there is a need in the art to provide improved galvanically-isolated communication circuits, which mitigate one or more of the drawbacks mentioned above.

### Object and summary

An object of one or more embodiments is to contribute in providing such improved galvanically-isolated communication circuits, and methods of transmitting a data signal across a capacitive isolation barrier.

According to one or more embodiments, such an object can be achieved by a communication circuit having the features set forth in the claims that follow.

One or more embodiments may relate to a corresponding method of transmitting a data signal across a capacitive isolation barrier.

The claims are an integral part of the technical teaching provided herein in respect of the embodiments.

According to an aspect of the present description, in a galvanically-isolated communication circuit an input terminal is configured to receive an input digital data signal. A first transmitter is configured to transmit a first carrier signal while the input digital data signal is asserted. A second transmitter is configured to transmit a second carrier signal while the input digital data signal is de-asserted. A first capacitive isolation barrier has a first terminal coupled to the output of the first transmitter to propagate the first carrier signal. A second capacitive isolation barrier has a first terminal coupled to the output of the second transmitter to propagate the second carrier signal. A receiver is coupled to the second terminals of the first capacitive isolation barrier and the second capacitive isolation barrier, and is configured to demodulate the first carrier signal to produce a replica of the input digital data signal, and demodulate the second carrier signal to produce a complemented replica of the input digital data signal. A selector is coupled to the outputs of the receiver and is configured to produce an output digital data signal at an output terminal of the communication circuit by passing the replica of the input digital data signal to the output terminal in response to a masking time interval elapsing after a falling edge of the output digital data signal, and passing the complement of the complemented replica of the input digital data signal to the output terminal in response to a masking time interval elapsing after a rising edge of the output digital data signal.

One or more embodiments may thus provide a galvanically-isolated communication channel with improved robustness to common mode transients (CMTs), symmetric propagation delays, constant current consumption, and no jitter.

According to another aspect of the present description, a method of transmitting a data signal across a capacitive isolation barrier includes:
- receiving an input digital data signal;
- transmitting, via a first capacitive isolation barrier, a first carrier signal while the input digital data signal is asserted;
- transmitting, via a second capacitive isolation barrier, a second carrier signal while the input digital data signal is de-asserted;
- demodulating the first carrier signal downstream of the first capacitive isolation barrier to produce a replica of the input digital data signal;
- demodulating the second carrier signal downstream of the second capacitive isolation barrier to produce a complemented replica of the input digital data signal; and
- producing an output digital data signal by:
- passing the replica of the input digital data signal in response to a masking time interval elapsing after a falling edge of the output digital data signal; and
- passing the complement of the complemented replica of the input digital data signal in response to a masking time interval elapsing after a rising edge of the output digital data signal.

### Brief description of the figures

One or more embodiments will now be described, by way of example only, with reference to the annexed figures, wherein:
- Figures 1A and 1B, previously presented, are circuit diagrams exemplary of two possible implementations of a communication channel through an embedded galvanic barrier according to the prior art;
- Figure 2 is a time diagram exemplary of the waveforms of signals in a communication channel using the pulse transmission technique;
- Figure 3 is a time diagram exemplary of the waveforms of signals in a communication channel using the pulse transmission technique with recovery procedure;
- Figure 4 is a time diagram exemplary of the waveforms of signals in a communication channel using OOK modulation;
- Figure 5 is a circuit diagram exemplary of a communication circuit having two channels in parallel, according to one or more embodiments of the present description;
- Figure 6 is a time diagram exemplary of the waveforms of signals in the circuit of Figure 5 using OOK modulation;
- Figure 7 is a circuit diagram exemplary of another communication circuit having two channels in parallel, according to one or more embodiments of the present description;
- Figure 8 is a time diagram exemplary of the waveforms of signals in the circuit of Figure 7 using OOK modulation;
- Figures 9 and 10 are two circuit diagrams exemplary of possible implementations of a transmitter circuit of the communication circuit of Figure 7, according to one or more embodiments of the present description;
- Figure 11 is a circuit diagram exemplary of a possible implementation of a receiver circuit of the communication circuit of Figure 7, according to one or more embodiments of the present description;
- Figure 12 is a circuit diagram exemplary of a possible implementation of a selector circuit of the communication circuit of Figure 7, according to one or more embodiments of the present description;
- Figure 13 is a circuit diagram exemplary of a possible detailed implementation of the communication circuit of Figure 7, according to one or more embodiments of the present description;
- Figures 14 and 15 are two circuit diagrams exemplary of possible implementations of a common mode transient filter circuit of the receiver circuit of the communication circuit of Figure 7, according to one or more embodiments of the present description;
- Figure 16 is a circuit diagram exemplary of a possible implementation of a trans-impedance amplifier stage of the receiver circuit of the communication circuit of Figure 7, according to one or more embodiments of the present description;
- Figure 17 is a circuit diagram exemplary of a possible implementation of a voltage amplifier stage of the receiver circuit of the communication circuit of Figure 7, according to one or more embodiments of the present description;
- Figure 18 is a circuit diagram exemplary of a possible implementation of a multiplier circuit of the receiver circuit of the communication circuit of Figure 7, according to one or more embodiments of the present description; and
- Figure 19 is a circuit diagram exemplary of the communication circuit of Figure 7 further including a fault detection circuit, according to one or more embodiments of the present description.

### Detailed description of exemplary embodiments

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is included in at least one embodiment. Hence, phrases such as "in an embodiment" or "in one embodiment" that may be present in one or more points of the present description do not necessarily refer to one and the same embodiment. Moreover, particular configurations, structures, or characteristics may be combined in any adequate way in one or more embodiments.

The headings/references used herein are provided merely for convenience and hence do not define the extent of protection or the scope of the embodiments.

Throughout the figures annexed herein, unless the context indicates otherwise, like parts or elements are indicated with like references/numerals and a corresponding description will not be repeated for the sake of brevity.

As anticipated, the present description relates to a galvanically-isolated communication circuit that aims at mitigating one or more of the drawbacks that the conventional communication circuits have, when using the pulse transmission technique or the OOK modulation technique. By way of introduction to the detailed description of exemplary embodiments, these two data transmission techniques are now discussed in detail.

Figure 2 is a time diagram exemplary of the waveforms of signals in the circuits of Figures 1A and 1B when using the pulse transmission technique. In particular, the following signals are represented: the input signal *Data_IN,* the pulsed signal *TX_OUT* at the output of the transmitter (104a or 104b), the output signal *Data_OUT,* the current *I_{L1}* flowing through the primary side of transformer 106a, the voltage *V_{C1}* across the first one of capacitors 112b, and the voltage *V_{C2}* across the second one of capacitors 112b. When the input data signal transitions from low to high (transition from "0" to "1" logic level) a pulse, conventionally positive, is transmitted from the transmitter through the galvanic isolation barrier and then it is demodulated from the receiver. When the input data signal transitions from high to low (transition from "1" to "0" logic level) another pulse, conventionally negative, is transmitted through the galvanic isolation barrier from the transmitter to the receiver, where it is demodulated. In the case of Figure 1A, the current *I_{L1}* is equal to zero in steady conditions, a positive current pulse indicates a low-to-high transition, and a negative current pulse indicates a high-to-low transition. In the case of Figure 1B, the voltages *V_{C1}* and *V_{C2}* are equal to *VDD*/2 (i.e., half of the supply voltage *VDD*) in steady conditions, and they are complementarily pushed to *VDD* or 0 V (ground) at each transition, so that the difference *V_{C1}-V_{C2}* having a positive pulse of amplitude equal to *VDD* indicates a low-to-high transition, and the difference *V_{C1}-V_{C2}* having a negative pulse of amplitude equal to *-VDD* indicates a high-to-low transition. So, the data input signal is reconstructed at the output of the communication channel with a propagation delay t_{d} that depends on the transmission and demodulation times. The propagation delay is symmetric, i.e., it is approximately the same for both low-to-high and high-to-low transitions. The pulse transmission technique can provide propagation delays of a few tens of nanoseconds and good matching but, as anticipated, shows weakness versus CMTs because the signal transmission can be lost during these events.

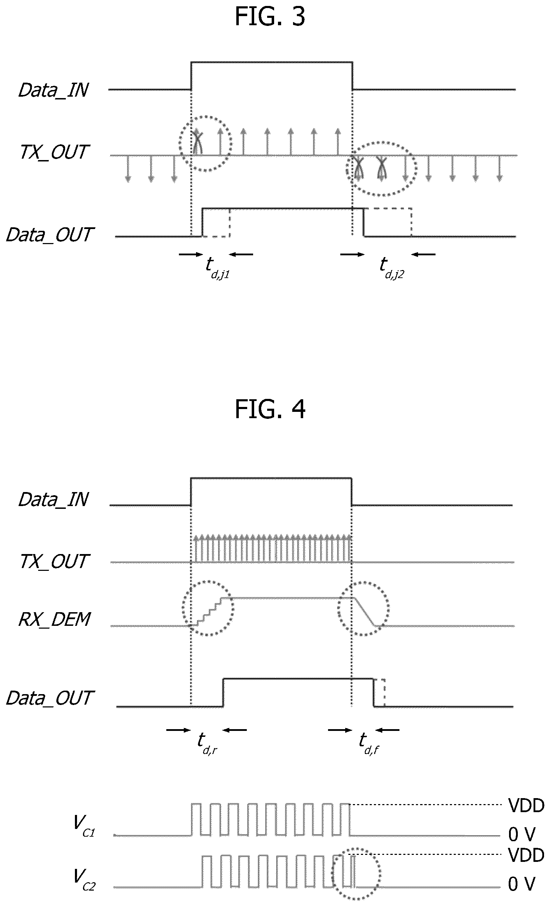

To improve robustness, a recovery procedure (also called refresh or retry procedure) is implemented, which relies on cyclically re-sending pulses according to the logic level of the input data signal *Data_IN,* as exemplified by the signal waveforms of Figure 3. However, cyclically re-sending pulses implies an increase of the current consumption and an increased complexity of the logic circuitry that manages the recovery procedure. Also, in case the signal transmission is lost during CMTs, this causes a visible additional jitter at the output of the receiver stage. The maximum extension of the additional jitter is equal (t_{d,j1}) to the recovery pulse period or is a multiple (t_{d,j2}) of the recovery pulse period.

Figure 4 is a time diagram exemplary of the waveforms of signals in the circuit of Figure 1B when using the OOK modulation transmission technique. In particular, the following signals are represented: the input signal *Data_IN,* the pulsed signal *TX_OUT* at the output of the transmitter 104b, the demodulation signal *RX_DEM* inside the receiver circuit, the output signal *Data_OUT,* the voltage *V_{C1}* across the first one of capacitors 112b, and the voltage *V_{C2}* across the second one of capacitors 112b. Differently from the pulse transmission technique, where the transition of the data signal between "0" and "1" is transmitted, the OOK modulation is intrinsically more robust, because it is based on the transmission of the logic level "0" or "1" of the input data signal and, in case the transmission is corrupted during CMTs, the signal integrity is recovered as soon as the transient elapses. However, OOK modulation implies longer and asymmetric propagation delays t_{d,r}, t_{d,f} and worse matching, because the demodulation of "1" and "0" logic levels is asymmetric by construction and involves different circuitry sections inside the receiver stage. Furthermore, it can be observed an asymmetric current consumption at the transmitter side which is maximum when "1" logic level is transmitted and minimum when "0" logic level is transmitted. In addition, since the carrier is not synchronized with the high-to-low transition of the input data signal, this causes a small jitter on the data output signal. The maximum duration of the jitter is equal to the period of the carrier.

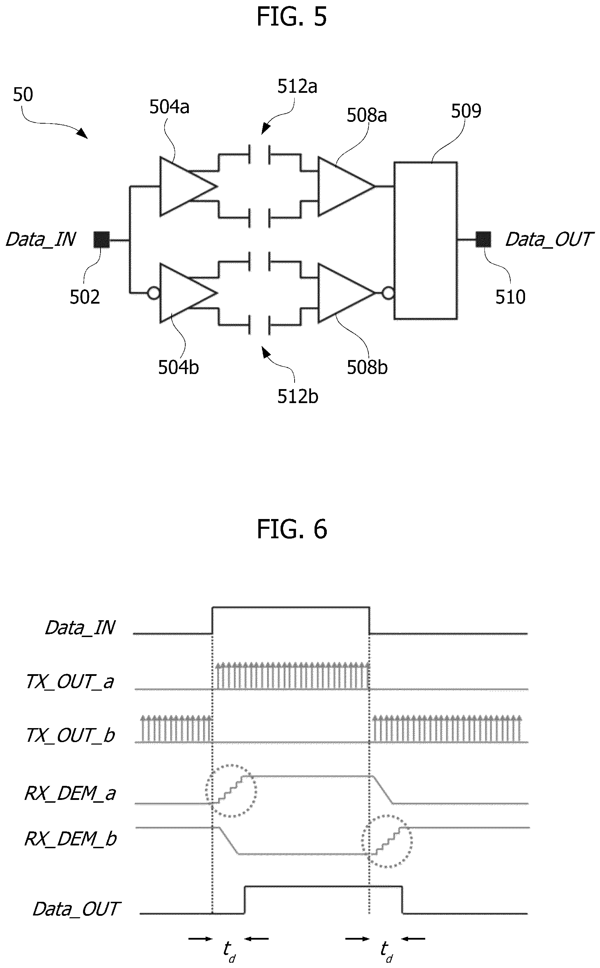

In order to take advantage of the robustness of OOK modulation without suffering from asymmetric propagation delays, poor matching, asymmetric power consumption and asymmetric jitter, embodiments of the present description rely on the idea of transmitting a carrier in both cases of "0" and "1" logic levels of the input signal, using two separated channels. This can be understood by referring to Figure 5, which is a circuit diagram exemplary of a communication circuit 50 having two channels in parallel, each being galvanically isolated with a respective pair of high-voltage capacitors. In particular, the communication circuit 50 includes an input terminal 502 configured to receive the input data signal *Data_IN,* a first transmitter circuit 504a coupled to the input terminal 502 and having a differential output, a first pair of HV capacitors 512a each having a first terminal coupled to a respective output of the transmitter 504a, a first receiver circuit 508a having a differential input coupled to the second terminals of the capacitors 512a, a second transmitter circuit 504b having a complemented input coupled to the input terminal 502 and having a differential output, a second pair of HV capacitors 512b each having a first terminal coupled to a respective output of the transmitter 504b, a second receiver circuit 508b having a differential input coupled to the second terminals of the capacitors 512b and a complemented output, a selector circuit 509 configured to select and pass one of the outputs from the receiver circuits 508a and 508b, and an output terminal 510 coupled to the selector 509 and configured to produce the output data signal *Data_OUT.* Therefore, the "normal" channel 504a, 512a, 508a is used to transmit the "1" logic level of the input signal, and the "complemented" channel 504b, 512b, 508b is used to transmit the "0" logic level of the input signal.

Operation of the communication circuit 50 can be understood with reference to Figure 6, which is a time diagram exemplary of the waveforms of signals in the circuit 50 when using the OOK modulation transmission technique. In particular, the following signals are represented: the input signal *Data_IN,* the pulsed differential signals *TX_OUT_a* and *TX_OUT_b* at the output of the transmitters 504a and 504b, the demodulation signals *RX*_*DEM_a* and *RX_DEM_b* inside the receiver circuits 508a and 508b, and the output signal *Data_OUT.* When the input data signal is at "1" logic level, a sequence of differential pulses is transmitted from transmitter 504a through HV capacitors 512a and then it is demodulated by receiver 508a. Similarly, when the input data signal is at "0" logic level, a sequence of differential pulses is transmitted via the HV capacitors 512b from the transmitter 504b to the receiver 508b, where it is demodulated. The selector 509 selects one of the two signals coming from receivers 508a and 508b, so the input data signal is reconstructed at the output terminal 510 of the communication channel with symmetric propagation delays t_{d}.

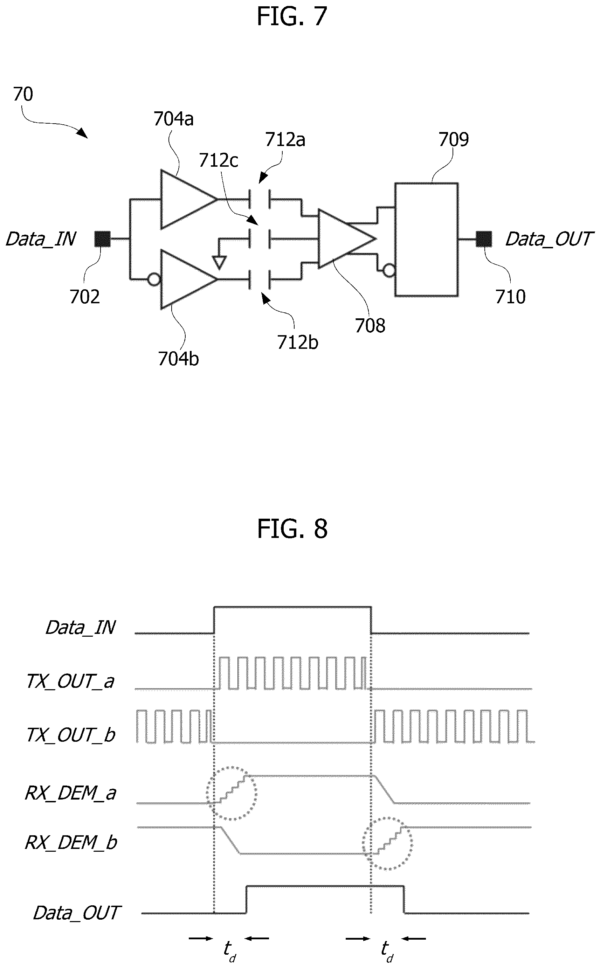

The implementation of Figure 5 may be further improved as exemplified in Figure 7, which is a circuit diagram exemplary of a communication circuit 70 also having two channels in parallel, but using single-ended transmitters, merging the receivers into a single-stage receiver with three inputs, and sharing one of the high-voltage isolation capacitors reducing their number from four to three. In particular, the communication circuit 70 includes an input terminal 702 configured to receive the input data signal *Data_IN,* a first transmitter circuit 704a coupled to the input terminal 702 and having a single-ended output, a first HV capacitor 712a having a first terminal coupled to the output of the transmitter 704a, a second transmitter circuit 704b having a complemented input coupled to the input terminal 702 and having a single-ended output, a second HV capacitor 712b having a first terminal coupled to the output of the transmitter 704b, a third HV capacitor 712c having a first terminal coupled to ground, a receiver circuit 708 having first, second and third input terminals respectively coupled to the second terminals of the first, second and third capacitors 712a, 712b, 712c and having a pair of complementary output terminals (i.e., a non-complemented one and a complemented one), a selector circuit 709 configured to select and pass one of the outputs from the receiver circuit 708, and an output terminal 710 coupled to the selector 709 and configured to produce the output data signal *Data_OUT.* Therefore, the "normal" channel 704a, 712a is used to transmit the "1" logic level of the input signal, and the "complemented" channel 704b, 712b is used to transmit the "0" logic level of the input signal.

Operation of the communication circuit 70 can be understood with reference to Figure 8, which is a time diagram exemplary of the waveforms of signals in the circuit 70 when using the OOK modulation transmission technique. In particular, the following signals are represented: the input signal *Data_IN,* the pulsed single-ended signals *TX_OUT_a* and *TX_OUT_b* at the output of the transmitters 704a and 704b, the demodulation signals *RX_DEM_a* and *RX_DEM_b* inside the receiver circuit 708 corresponding respectively to the channel 704a and 704b, and the output signal *Data_OUT.* When the input data signal is at "1" logic level, a single-ended square waveform (oscillating between *VDD* and 0 V) is transmitted from transmitter 704a through a HV capacitor 712a and then it is demodulated by a first part of receiver 708. Similarly, when the input data signal is at "0" logic level, a single-ended square waveform (oscillating between *VDD* and 0 V) is transmitted from transmitter 704b to a second part of receiver 708, where it is demodulated. The selector 709 selects one of the two signals coming from the receiver 708, so the input data signal is reconstructed at the output terminal 710 of the communication channel with symmetric propagation delays t_{d}. The third HV capacitor 712c is used to discriminate the data signal from common mode transients CMTs.

The circuit of Figure 7 thus leads to the advantage of having symmetric propagation delays and constant current consumption, as the carrier is transmitted for both "0" and "1" logic levels. On the other hand, the separation of the transmission path relies on the use of three high-voltage capacitors.

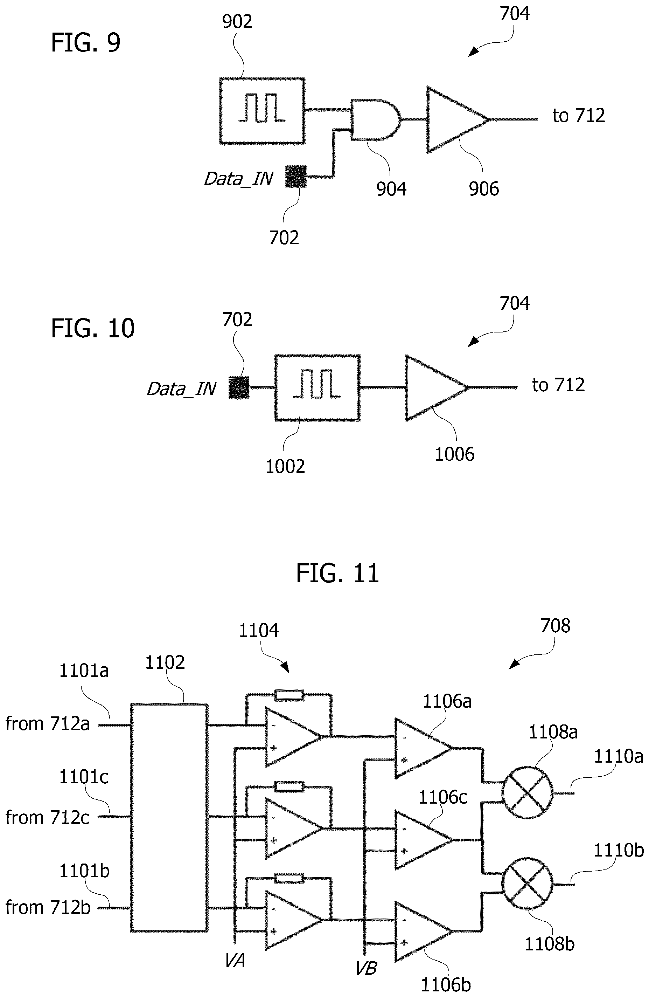

Figures 9 and 10 are two circuit diagrams exemplary of possible implementations of the transmitters 704a and 704b (also individually or generically referred to with reference number 704) according to embodiments of the present description. In the embodiment of Figure 9, the transmitter 704 includes a free-running oscillator 902 that continuously generates a square waveform, a logic gate 904 coupled to the output of oscillator 902 configured to selectively enable propagation of the square waveform depending on the value of the input data signal *Data_IN,* and a buffer 906 coupled to the output of the logic gate 904 and configured to be directly connected to the first terminal of a respective HV capacitor 712 (i.e., capacitor 712a for transmitter 704a and capacitor 712b for transmitter 704b). The logic gate 904 may be an AND gate having a first input coupled to oscillator 902 and a second input configured to receive the signal *Data_IN.* In the embodiment of Figure 10, the transmitter 704 includes an oscillator 1002 that generates a square waveform when activated by the input data signal *Data_IN* (i.e.*,* when signal *Data_IN* is high), and a buffer 1006 coupled to the output of the oscillator 1002 and configured to be directly connected to the first terminal of a respective HV capacitor 712 (i.e., capacitor 712a for transmitter 704a and capacitor 712b for transmitter 704b). The embodiment of Figure 10 is preferable insofar as its oscillator starts synchronously with the signal *Data IN,* thus preventing jitter in the low-to-high transition of signal *Data_IN.*

Figure 11 is a circuit diagram exemplary of a possible implementation of the receiver 708 according to embodiments of the present description. The receiver 708 includes a common mode transient filter 1102 (CMT filter) having three input terminals 1101a, 1101b, and 1101c directly connected to the second terminals of capacitors 712a, 712b and 712c, respectively. Terminal 1101a receives signal *TX_OUT_a* from transmitter 704a via capacitor 712a, terminal 1101b receives signal *TX_OUT_b* from transmitter 704b via capacitor 712b, and terminal 1101c is coupled to ground via capacitor 712c. The CMT filter 1102 is configured to reject the common mode transients. The CMT filter 1102 has three respective output terminals, each of which is coupled to a first (e.g., inverting) input terminal of a respective trans-impedance (TI) amplifier 1104a, 1104b, 1104c. The second (e.g., non-inverting) input terminal of each trans-impedance amplifier 1104 is configured to receive a voltage *VA.* Each trans-impedance amplifier 1104 may include an operational amplifier and a feedback resistor arranged between the output and the first input of the operational amplifier. The output terminal of each trans-impedance amplifier 1104a, 1104b, 1004c is coupled to a first (e.g., inverting) input terminal of a respective voltage amplifier 1106a, 1106b, 1106c. The second (e.g., non-inverting) input terminal of each voltage amplifier 1106 is configured to receive a voltage *VB.* The pair of signals output by amplifiers 1106a and 1106c, corresponding to signals coming from terminals 1101a and 1101c, is fed to a first multiplier circuit implemented, for example, as a Gilbert multiplier 1108a. The pair of signals output by amplifiers 1106b and 1106c, corresponding to signals coming from terminals 1101b and 1101c, is fed to a second multiplier circuit implemented, for example, as a Gilbert multiplier 1108b. In this way, the output terminal 1110a of multiplier 1108a reconstructs the signal *TX_OUT_a* of transmitter 704a, and the output terminal 1110b of multiplier 1108b reconstructs the signal *TX_OUT_b* of transmitter 704b.

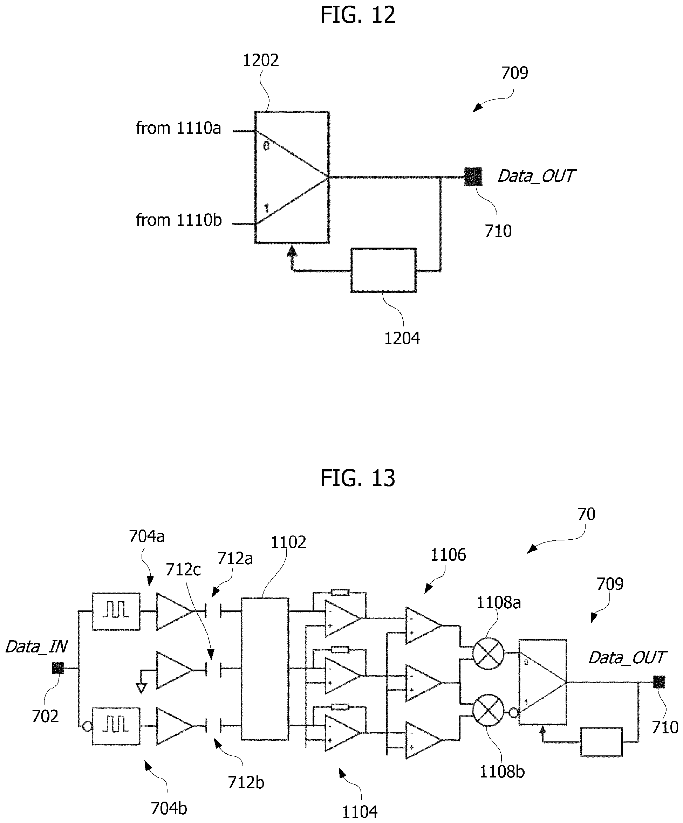

Figure 12 is a circuit diagram exemplary of a possible implementation of the selector 709 according to embodiments of the present description. The selector 709 includes a digital multiplexer 1202 having inputs directly connected to the output terminals 1110a and 1110b of the receiver 708, where the inputs are selected according to the status of the output signal *Data_OUT,* according to the following rule. If the output signal *Data_OUT* is low then, after a proper masking time (e.g., indicated by the block 1204 in Figure 12), the signal coming from terminal 1110a is selected and passed to the output terminal 710, while if the output signal *Data_OUT* is high then, after the masking time, the signal coming from terminal 1110b is selected and passed. Therefore, the input signal *Data IN* from terminal 702 is entirely reconstructed at terminal 710 as an output signal *Data_OUT.*

Figure 13 is a circuit diagram exemplary of a possible detailed implementation of the communication circuit 70 of Figure 7, using the implementations exemplified in Figures 10, 11 and 12. It will be noted that a buffer can optionally be coupled between ground and the first terminal of capacitor 712c so as to equalize the impedance at the input of the three capacitors 712a, 712b and 712c.

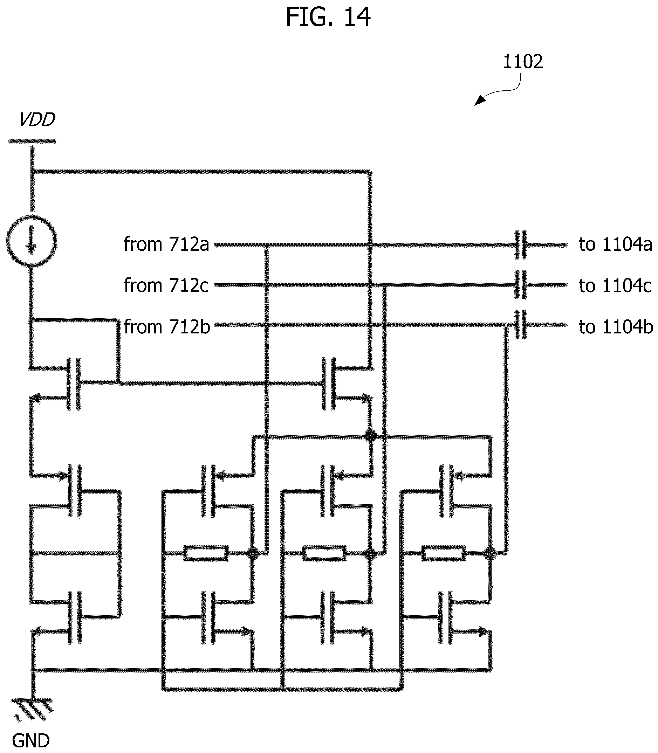

In the following, further possible implementation details of the blocks of the receiver 708 will be disclosed with reference to Figures 14 to 18.

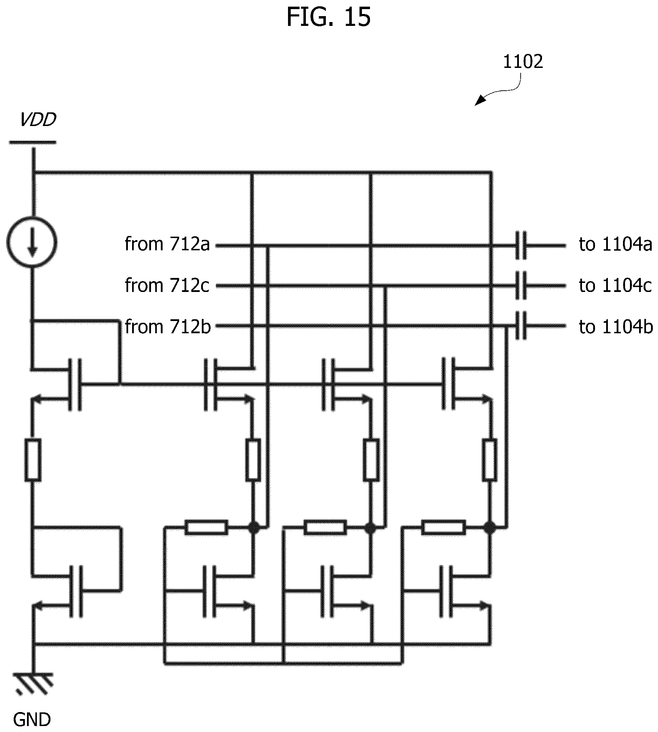

In particular, Figures 14 and 15 are two circuit diagrams exemplary of possible implementations of the CMT filter 1102 according to embodiments of the present description. In both implementations, the CMT filter 1102 includes three input terminals, each coupled to a corresponding one of the high-voltage capacitors 712, and three respective output terminals, each one coupled to a corresponding one of the trans-impedance amplifiers 1104. The output of a respective half-bridge stage is coupled to each input terminal of the filter 1102 (and thus to each HV capacitor 712), offering low impedance at common mode transients and high impedance at differential signals. The transistors of the three half-bridge stages are biased via a fourth stage. A low-voltage (LV) capacitor is arranged between each input terminal and its respective output terminal (i.e., at the output of the CMT filter) for decoupling the DC voltage level from the outputs of the filter to the inputs of the trans-impedance amplifiers 1104.

Specifically, in the embodiment of Figure 14, each half-bridge stage includes (e.g., consists of) a pMOS transistor and an nMOS transistor arranged in push-pull configuration. In each half-bridge stage, the gate terminals of the pMOS and nMOS transistors are coupled to each other and are connected to the common drain node of the half-bridge via a resistor, which has the purpose of increasing the differential mode impedance while keeping the common mode impedance unchanged. The gate terminals of the transistors of the three half-bridges are all coupled together, the source terminals of the pMOS transistors of the three half-bridges are all coupled to a common biasing node, and the source terminals of the nMOS transistors of the three half-bridges are all coupled to ground. The biasing stage (fourth stage) includes (e.g., consists of) a pMOS transistor and an nMOS transistor arranged in push-pull configuration. The gate terminals of the pMOS and nMOS transistors of the biasing stage are coupled to each other and are (e.g., directly) connected to the common drain node of the half-bridge. The source terminal of the pMOS transistor of the biasing stage is coupled to the source terminal of a diode-connected nMOS transistor that operates as the first branch of a current mirror. The source terminal of the nMOS transistor of the biasing stage is coupled to ground. A further nMOS transistor has a gate terminal coupled to the gate terminal of the diode-connected transistor and a source terminal coupled to the common biasing node of the three filter half-bridges to operate as the second branch of the current mirror, so that the biasing voltage of the fourth half-bridge stage is replicated on the common biasing node of the three half-bridge stages.

By way of comparison, in the embodiment of Figure 15, each half-bridge stage includes (e.g., consists of) two nMOS transistors arranged in push-pull configuration. In each half-bridge stage, the gate terminal of the low-side transistor is connected in diode configuration to the drain terminal of the low-side transistor via a resistor, which has the purpose of increasing the differential mode impedance while keeping the common mode impedance unchanged. The gate terminals of the low-side transistors of the three half-bridges are all coupled together, and the source terminals of the low-side transistors of the three half-bridges are all coupled to ground. The drain terminals of the high-side transistors of the three half-bridges are all coupled to the main biasing node *VDD.* In each half-bridge stage, the source terminal of the high-side transistor is coupled to the drain terminal of the respective low-side transistor (e.g., via a resistor, having the purpose of increasing the differential mode impedance). The biasing stage (fourth stage) includes (e.g., consists of) two nMOS transistors arranged in push-pull configuration. The gate terminal of the low-side transistor of the biasing stage is (e.g., directly) connected in diode configuration to its drain terminal. The source terminal of the low-side transistor of the biasing stage is coupled to ground. The source terminal of the high-side transistor of the biasing stage is coupled to the drain terminal of the respective low-side transistor (e.g., via a resistor, having the purpose of increasing the differential mode impedance). The gate terminal of the high-side transistor of the biasing stage is coupled to its drain terminal in diode configuration, and it is further coupled to the gate terminals of all the high-side transistors of the three filter half-bridge stages. The embodiment of Figure 15 is preferable over the embodiment of Figure 14 insofar as it has a wider supply range.

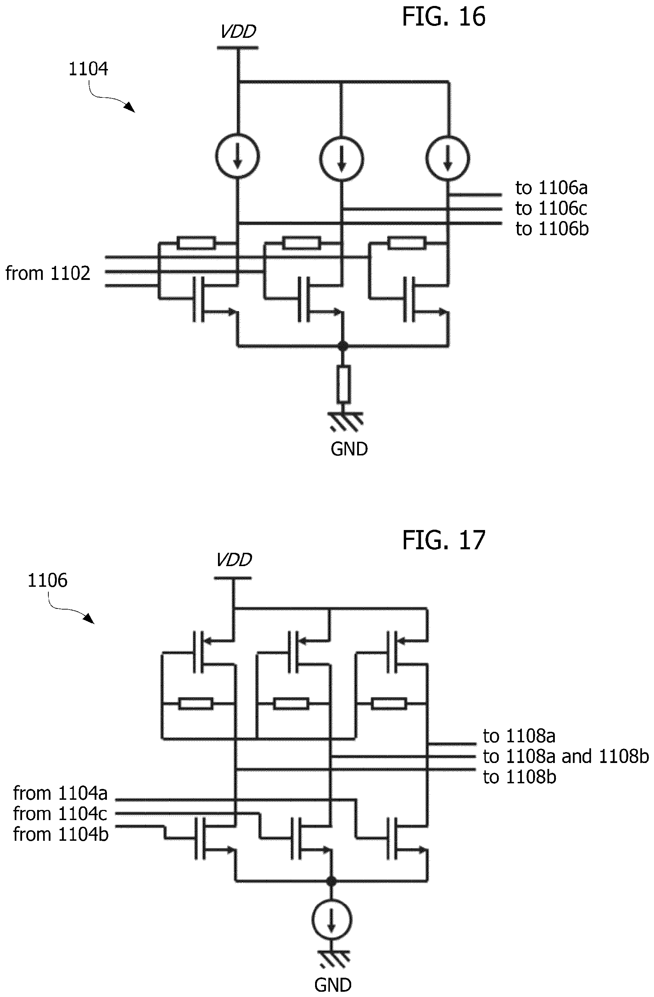

Figure 16 is a circuit diagram exemplary of a possible implementation of the trans-impedance amplifiers 1104a, 1104b and 1104c according to embodiments of the present description. Each TI amplifier 1104 may be implemented as a single-stage amplifier, which includes (e.g., consists of) an nMOS transistor, biased by a respective current generator arranged in series between the main biasing node *VDD* and the drain terminal of the nMOS transistor. The gate terminal of each nMOS transistor is coupled to a respective output of the CMT filter 1102 (i.e., it operates as the input node of the TI amplifier), and the source terminals of all three nMOS transistors are coupled together and then to ground (e.g., via a common resistor, which has the purpose of adjusting the DC voltage level). Each TI amplifier 1104 includes a respective feedback resistor connected between the output node (drain terminal) and the input node (gate terminal), which has the purpose of reducing the input impedance.

Figure 17 is a circuit diagram exemplary of a possible implementation of the voltage amplifiers 1106a, 1106b and 1106c according to embodiments of the present description. Each voltage amplifier 1106 may be implemented as a single-stage amplifier, which includes (e.g., consists of) an nMOS transistor loaded by a respective diode-connected pMOS transistor arranged in series between the main biasing node *VDD* and the drain terminal of the nMOS transistor. The gate terminal of each nMOS transistor is coupled to the output of a respective TI amplifier 1104 (i.e., it operates as the input node of the voltage amplifier), and the source terminals of all three nMOS transistors are coupled together and then to ground (e.g., via a common current source, which sinks a current from the common source node of the nMOS transistors). Each pMOS transistor has a source terminal coupled to the main biasing node *VDD,* and a gate terminal coupled to the respective drain terminal (e.g., via a resistor, having the purpose of increasing the differential mode impedance while keeping the common mode impedance unchanged). The gate terminals of all the pMOS transistors are coupled together. The drain terminal of each pMOS transistor is coupled to the drain terminal of the respective nMOS transistor, and the drain terminal of each nMOS transistor operates as the output node of the voltage amplifier. The output of the first voltage amplifier 1106a is passed to the first Gilbert multiplier 1108a, the output of the second voltage amplifier 1106b is passed to the second Gilbert multiplier 1108b, and output of the third voltage amplifier 1106c is passed to both the first Gilbert multiplier 1108a and the second Gilbert multiplier 1108b (as illustrated in Figure 11).

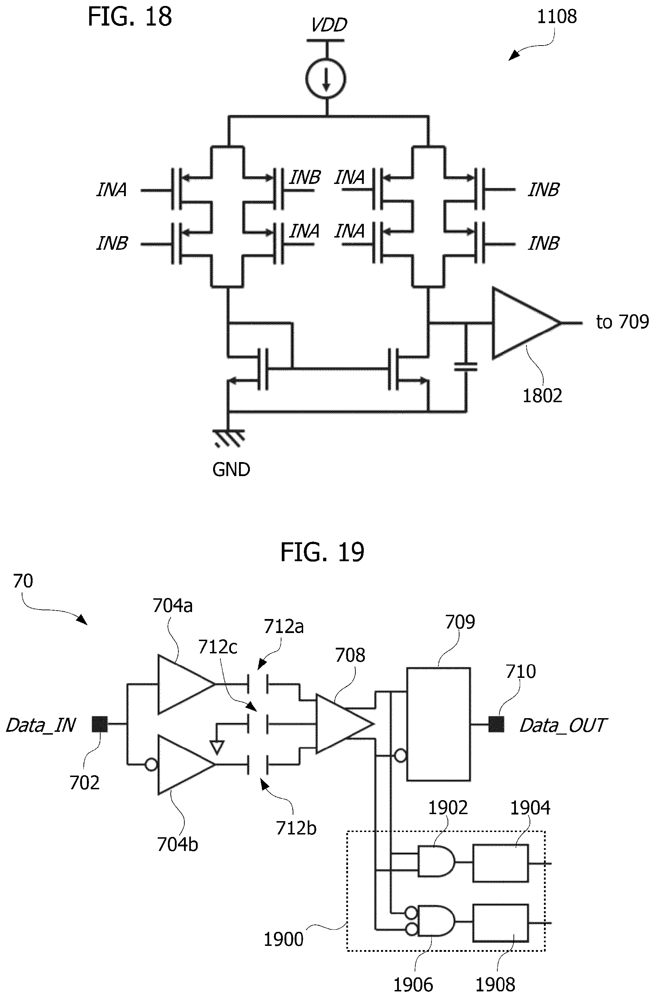

Figure 18 is a circuit diagram exemplary of a possible implementation of each of the Gilbert multipliers 1108a and 1108b according to embodiments of the present description. Each multiplier 1108 receives two input signals, generically indicated in Figure 18 as signals *INA* and *INB.* Each multiplier 1108 may include (e.g., consist of) a differential stage, implemented with eight pMOS transistors, cross-driven by signals *INA* and *INB* (i.e., the outputs of the voltage amplifiers 1106 as illustrated in Figure 11), and a current mirror, implemented with nMOS transistors, which has the purpose of converting the signal from differential to single-ended. In particular, a first current flow line (left one in Figure 18) includes two parallel current branches, the first branch including two series-connected pMOS transistors receiving signals *INA* and *INB* at their gate terminals, and the second branch including two series-connected pMOS transistors receiving signals *INB* and *INA* at their gate terminals. A second current flow line (right one in Figure 18) also includes two parallel current branches, the first branch including two series-connected pMOS transistors both receiving signal *INA* at their gate terminals, and the second branch including two series-connected pMOS transistors both receiving signal *INB* at their gate terminals. A first, diode-connected nMOS transistor is coupled between the tail of the first current flow line and ground (operating as the first branch of the current mirror), and a second nMOS transistor is coupled between the tail of the second current flow line and ground and has a gate terminal coupled to the gate terminal of the diode-connected nMOS transistor (operating as the second branch of the current mirror). A capacitor is arranged between the output node of the current mirror (i.e., the drain terminal of the second nMOS transistor) and ground, and has a trade-off capacitance value to filter noise and minimize the propagation delay. The signal at the output node of the current mirror is buffered by a buffer 1802 and then passed as output to the selector circuit 709, as illustrated in Figure 13.

It is noted that, in a communication channel according to the present description, a signal (carrier) is transmitted in both cases of "0" or "1" logic levels of the input data signal. During normal operation, one of the outputs of the receiver 708 is expected to be high and the other is expected to be low. If both outputs of receiver 708 are low, the transmitter circuit has gone in undervoltage or any other generic fault has occurred. On the other hand, if both outputs of receiver 708 are high, a generic fault has occurred as well. Therefore, by monitoring the outputs of the receiver circuit 708, it is possible to detect a generic fault, e.g., by using a fault detection circuit 1900 as illustrated in the circuit diagram of Figure 19. The fault detection circuit may comprise a first AND gate 1902 configured to assert a first fault signal if both outputs from the receiver 708 are high (possibly applying a masking time 1904, so as to take into account possible small differences in the propagation delays of the two channels of the communication circuit) and a second AND gate 1906 configured to assert a second fault signal if both the complemented outputs from the receiver 708 are high (possibly applying a masking time 1908). It is noted that the same fault detection circuit may be applied to the embodiments of Figure 5, taking as inputs the signals from receivers 508a and 508b.

One or more embodiments may thus provide one or more of the following advantages:
- improved robustness to common mode transients (CMTs);
- symmetric propagation delays;
- constant current consumption;
- no jitter;
- possibility to detect faults by comparing the two outputs of the receiver.

Without prejudice to the underlying principles, the details and embodiments may vary, even significantly, with respect to what has been described by way of example only, without departing from the extent of protection.

The extent of protection is determined by the annexed claims.

## Claims

1. A galvanically-isolated communication circuit (50; 70), comprising:
an input terminal (502; 702) configured to receive an input digital data signal (*Data_IN*);
a first transmitter (504a; 704a) configured to transmit a first carrier signal (*TX_OUT_a*) while said input digital data signal *(Data_IN)* is asserted;
a second transmitter (504b; 704b) configured to transmit a second carrier signal (*TX_OUT_b*) while said input digital data signal *(Data_IN)* is de-asserted;
a first capacitive isolation barrier (512a; 712a) having a first terminal coupled to the output of said first transmitter (504a; 704a) to propagate said first carrier signal (*TX_OUT_a*);
a second capacitive isolation barrier (512b; 712b) having a first terminal coupled to the output of said second transmitter (504b; 704b) to propagate said second carrier signal (*TX_OUT_b*);
a receiver (508a, 508b; 708) coupled to the second terminals of said first capacitive isolation barrier (512a; 712a) and said second capacitive isolation barrier (512b; 712b), and configured to:
demodulate said first carrier signal (*TX_OUT_a*) to produce a replica of said input digital data signal (*Data_IN*); and
demodulate said second carrier signal (*TX_OUT_b*) to produce a complemented replica of said input digital data signal (*Data_IN*); and
a selector (509; 709) coupled to the outputs of said receiver and configured to produce an output digital data signal (*Data_OUT*) at an output terminal (510; 710) of the communication circuit by:
passing said replica of said input digital data signal (*Data_IN*) to said output terminal (510; 710) in response to a masking time interval elapsing after a falling edge of said output digital data signal (*Data_OUT*); and
passing the complement of said complemented replica of said input digital data signal (*Data_IN*) to said output terminal (510; 710) in response to a masking time interval elapsing after a rising edge of said output digital data signal (*Data_OUT*).

2. The circuit (50) of claim 1, wherein:
said first transmitter (504a) has a differential output, and said first carrier signal (*TX_OUT_a*) comprises a train of positive pulses while said input digital data signal (*Data_IN*) is asserted and no pulses while said input digital data signal (*Data_IN*) is de-asserted;
said second transmitter (504b) has a differential output, and said second carrier signal (*TX_OUT_b*) comprises a train of positive pulses while said input digital data signal (*Data_IN*) is de-asserted and no pulses while said input digital data signal (*Data_IN*) is asserted;
said first capacitive isolation barrier (512a) comprises a first pair of capacitors having respective first terminals coupled to the differential output of said first transmitter (504a);
said second capacitive isolation barrier (512b) comprises a second pair of capacitors having respective first terminals coupled to the differential output of said second transmitter (504b);
said receiver comprises:
a first receiver (508a) having a differential input coupled to the second terminals of said first pair of capacitors; and
a second receiver (508b) having a differential input coupled to the second terminals of said second pair of capacitors.

3. The circuit (70) of claim 1, wherein:
said first transmitter (704a) has a single-ended output, and said first carrier signal (*TX_OUT_a*) comprises a square wave while said input digital data signal (*Data_IN*) is asserted and is steadily de-asserted while said input digital data signal (*Data_IN*) is de-asserted;
said second transmitter (704b) has a single-ended output, and said second carrier signal (*TX_OUT_b*) comprises a square wave while said input digital data signal (*Data_IN*) is de-asserted and is steadily de-asserted while said input digital data signal (*Data_IN*) is asserted;
said first capacitive isolation barrier (712a) comprises a first capacitor (712a) having a first terminal coupled to the single-ended output of said first transmitter (704a);
said second capacitive isolation barrier (712b) comprises a second capacitor (712b) having a first terminal coupled to the single-ended output of said second transmitter (704b);
said receiver (708) has a first single-ended input (1101a) coupled to the second terminal of said first capacitor (712a), a second single-ended input (1101b) coupled to the second terminal of said second capacitor (712b), and a third single-ended input (1101c) coupled to the second terminal of a third capacitor (712c), wherein the first terminal of the third capacitor (712c) is coupled to ground.

4. The circuit (70) of claim 3, wherein said first transmitter (704a) and second transmitter (704b) comprise a free-running oscillator (902), and wherein:
said first transmitter (704a) comprises an AND logic gate (904) configured to combine the output of said free-running oscillator (902) and said input digital data signal (*Data_IN*)*,* and a buffer (906) coupled between the output of the AND logic gate (904) and the first terminal of said first capacitor (712a); and
said second transmitter (704b) comprises an AND logic gate (904) configured to combine the output of said free-running oscillator (902) and the complement of said input digital data signal (*Data_IN*)*,* and a buffer (906) coupled between the output of the AND logic gate (904) and the first terminal of said second capacitor (712b).

5. The circuit (70) of claim 3 or claim 4, wherein:
said first transmitter (704a) comprises a first oscillator (1002) activatable to generate a square waveform synchronously with the asserted state of said input digital data signal (*Data_IN*)*,* and a buffer (1006) coupled between the output of the first oscillator (1002) and the first terminal of said first capacitor (712a); and
said second transmitter (704b) comprises a second oscillator (1002) activatable to generate a square waveform synchronously with the asserted state of the complement of said input digital data signal (*Data_IN*)*,* and a buffer (1006) coupled between the output of the second oscillator (1002) and the first terminal of said second capacitor (712b).

6. The circuit (70) of any of claims 3 to 5, wherein said receiver (708) comprises:
a common mode transient, CMT, filter (1102) having three input nodes respectively coupled to said first, second and third single-ended input terminals (1101a, 1101b, 1101c) of the receiver (708), and having three respective output nodes;
first (1104a), second (1104b) and third (1104c) trans-impedance amplifiers, each having a first input terminal coupled to a respective output node of the CMT filter (1102), and an output terminal;
first (1106a), second (1106b) and third (1106c) voltage amplifiers, each having a first input terminal coupled to the output terminal of a respective trans-impedance amplifiers (1104a, 1104b, 1004c), and an output terminal;
a first Gilbert multiplier (1108a) coupled to the output terminals of said first (1106a) and third (1106c) voltage amplifiers, and configured to produce said replica of said input digital data signal (*Data_IN*); and
a second Gilbert multiplier (1108b) coupled to the output terminals of said second (1106b) and third (1106c) voltage amplifiers, and configured to produce said complemented replica of said input digital data signal (*Data_IN*)*.*

7. The circuit (70) of claim 6, wherein said CMT filter (1102) comprises a biasing half-bridge stage and further comprises, for each of the three input nodes of the CMT filter, a respective filter half-bridge stage having an output coupled to the input node of the CMT filter, and a capacitor arranged in series between the input node of the CMT filter and the respective output node of the CMT filter;
wherein each filter half-bridge stage comprises a pMOS transistor and an nMOS transistor arranged in push-pull configuration, wherein a gate terminal of the pMOS transistor and a gate terminal of the nMOS transistor are coupled to each other and are connected to a common drain node of the filter half-bridge stage via a resistor;
wherein the gate terminals of the pMOS transistors and nMOS transistors of the three filter half-bridges are all coupled together, the source terminals of the pMOS transistors of the three filter half-bridges are all coupled to a common biasing node, and the source terminals of the nMOS transistors of the three filter half-bridges are all coupled to ground;
wherein the biasing half-bridge stage comprises a pMOS transistor and an nMOS transistor arranged in push-pull configuration, wherein a gate terminal of the pMOS transistor and a gate terminal of the nMOS transistor are coupled to each other and are connected to a common drain node of the biasing half-bridge stage; wherein the source terminal of the pMOS transistor of the biasing half-bridge stage is coupled to the source terminal of a diode-connected nMOS transistor, and the source terminal of the nMOS transistor of the biasing half-bridge stage is coupled to ground;
wherein the CMT filter comprises a further nMOS transistor having a gate terminal coupled to the gate terminal of the diode-connected transistor and a source terminal coupled to the common biasing node.

8. The circuit (70) of claim 6, wherein said CMT filter (1102) comprises a biasing half-bridge stage and further comprises, for each of the three input nodes of the CMT filter, a respective filter half-bridge stage having an output coupled to the input node of the CMT filter, and a capacitor arranged in series between the input node of the CMT filter and the respective output node of the CMT filter;
wherein each filter half-bridge stage comprises a high-side nMOS transistor and a low-side nMOS transistor arranged in push-pull configuration, wherein a gate terminal of the low-side nMOS transistor is connected in diode configuration to the drain terminal of the low-side nMOS transistor via a resistor, and wherein the source terminal of the high-side nMOS transistor is coupled to the drain terminal of the low-side nMOS transistor via a resistor;
wherein the gate terminals of the low-side nMOS transistors of the three filter half-bridges are all coupled together, the source terminals of the low-side nMOS transistors of the three filter half-bridges are all coupled to ground, and the drain terminals of the high-side nMOS transistors of the three filter half-bridges are all coupled to a main biasing node (*VDD*);
wherein the biasing half-bridge stage comprises a high-side nMOS transistor and a low-side nMOS transistor arranged in push-pull configuration, wherein a gate terminal of the low-side nMOS transistor is connected in diode configuration to the drain terminal of the low-side nMOS transistor, the source terminal of the low-side nMOS transistor is coupled to ground, the source terminal of the high-side nMOS transistor is coupled to the drain terminal of the low-side nMOS transistor via a resistor, the gate terminal of the high-side nMOS transistor is coupled in diode configuration to the drain terminal of the high-side nMOS transistor, and the gate terminal of the high-side nMOS transistor is further coupled to the gate terminals of the high-side nMOS transistors of the three filter half-bridge stages.

9. The circuit (70) of any of claims 6 to 8, wherein each of said first (1104a), second (1104b) and third (1104c) trans-impedance amplifiers comprises:
an nMOS transistor having a gate terminal coupled to a respective output of the CMT filter (1102), a current generator arranged in series between a main biasing node (*VDD*) and a drain terminal of the nMOS transistor, and a feedback resistor connected between the drain terminal and the gate terminal of the nMOS transistor;
wherein the source terminals of the three nMOS transistors of the three trans-impedance amplifiers (1104a, 1104b, 1104c) are coupled together to a common source terminal, and the common source terminal is coupled to ground via a resistor.

10. The circuit (70) of any of claims 6 to 9, wherein each of said first (1106a), second (1106b) and third (1106c) voltage amplifiers comprises:
an nMOS transistor and a pMOS transistor, the pMOS transistor being arranged in series between a main biasing node (*VDD*) and the drain terminal of the nMOS transistor, wherein the gate terminal of the nMOS transistor is coupled to the output of a respective one of said first (1104a), second (1104b) and third (1104c) trans-impedance amplifiers, wherein the gate terminal of the pMOS transistor is coupled to the drain terminal of the pMOS transistor via a resistor;
wherein the source terminals of the three nMOS transistors of the three voltage amplifiers (1106a, 1006b, 1106c) are coupled together to a common source terminal, and the common source terminal is coupled to ground via a current source, and wherein the gate terminals of the three pMOS transistors of the three voltage amplifiers (1106a, 1006b, 1106c) are coupled together.

11. The circuit (70) of any of claims 6 to 10, wherein said first Gilbert multiplier (1108a) comprises a first differential stage cross-driven by the output terminals of said first (1106a) and third (1106c) voltage amplifiers, a first current mirror coupled to the first differential stage to convert the differential signal output by the first differential stage to a first single-ended multiplied signal, and a first capacitor arranged between an output node of the first current mirror and ground; and wherein said second Gilbert multiplier (1108b) comprises a second differential stage cross-driven by the output terminals of said second (1106b) and third (1106c) voltage amplifiers, a second current mirror coupled to the second differential stage to convert the differential signal output by the second differential stage to a second single-ended multiplied signal, and a second capacitor arranged between an output node of the second current mirror and ground.

12. The circuit (70) of any of the previous claims, further comprising a fault detection circuit (1900) configured to assert a first fault signal if both outputs from the receiver (508a, 508b; 708) are asserted and assert a second fault signal if both the complemented outputs from the receiver (508a, 508b; 708) are asserted.

13. The circuit (50; 70) of any of the previous claims, wherein said selector (509; 709) comprises a digital multiplexer (1202) having a first input configured to receive said replica of said input digital data signal (*Data_IN*), *a* second input configured to receive said complement of said complemented replica of said input digital data signal (*Data_IN*)*,* and an output directly coupled to said output terminal (510; 710) of the communication circuit;
wherein said digital multiplexer (1202) is controlled by a delayed (1204) replica of said output digital data signal (*Data_OUT*)*.*

14. A method of transmitting a data signal across a capacitive isolation barrier, the method comprising:
receiving an input digital data signal (*Data_IN*);
transmitting, via a first capacitive isolation barrier (512a; 712a), a first carrier signal (*TX_OUT_a*) while said input digital data signal (*Data_IN*) is asserted;
transmitting, via a second capacitive isolation barrier (512b; 712b), a second carrier signal (*TX_OUT_b*) while said input digital data signal (*Data_IN*) is de-asserted;
demodulating said first carrier signal (*TX_OUT_a*) downstream of said first capacitive isolation barrier (512a; 712a) to produce a replica of said input digital data signal (*Data_IN*);
demodulating said second carrier signal (*TX_OUT_b*) downstream of said second capacitive isolation barrier (512b; 712b) to produce a complemented replica of said input digital data signal (*Data_IN*); and
producing an output digital data signal (*Data_OUT*) by:
passing said replica of said input digital data signal (*Data_IN*) in response to a masking time interval elapsing after a falling edge of said output digital data signal (*Data_OUT*); and
passing the complement of said complemented replica of said input digital data signal (*Data_IN*) in response to a masking time interval elapsing after a rising edge of said output digital data signal (*Data_OUT*)*.*
